Europäisches Patentamt

European Patent Office

Office Européen des brevets

(11) Veröffentlichungsnummer : **0 262 431 B1**

## (12) EUROPÄISCHE PATENTSCHRIFT

(45) Veröffentlichungstag der Patentschrift :
02.01.91 Patentblatt 91/01

(51) Int. Cl.⁵ : **H05K 7/20, H05K 5/02**

(21) Anmeldenummer : 87112762.7

(22) Anmeldetag : 02.09.87

(54) Wärmeschutzgehäuse.

(30) Priorität : 29.09.86 CH 3897/86

(43) Veröffentlichungstag der Anmeldung :
06.04.88 Patentblatt 88/14

(45) Bekanntmachung des Hinweises auf die
Patenterteilung :
02.01.91 Patentblatt 91/01

(84) Benannte Vertragsstaaten :
CH DE FR GB LI SE

(56) Entgegenhaltungen :
DE-U- 6 930 521
DE-U- 7 038 595
GB-A- 2 094 947

(73) Patentinhaber : BBC Brown Boveri AG
Haselstrasse
CH-5401 Baden (CH)

(72) Erfinder : Maschek, Martin
Florastrasse 33
CH-8116 Würenlos (CH)
Erfinder : Mastner, Georg
Loonstrasse 5
CH-5443 Niederrohrdorf (CH)

Jouve, 18, rue Saint-Denis, 75001 PARIS

## Description

### Technisches Gebiet

Bei der Erfindung wird ausgegangen von einer Wärmeschutzanordnung eines elektronischen Gerätes nach dem Oberbegriff des Patentanspruchs 1.

### Stand der Technik

Mit dem Oberbegriff nimmt die Erfindung auf einen Stand der Technik von Wärmeschutzanordnungen Bezug, wie er aus der deutschen Zeitschrift : Feingerätetechnik, 9. Jg., 4 (1960) S. 148 - 153 bekannt ist. Durch Löcher in Deck- und Grundplattennähe des Wärmeschutzgehäuses und durch einen dazwischenliegenden, möglichst langen Strömungskanal wird eine Kaminwirkung und damit eine gute Wärmeabfuhr durch Konvektion erreicht. Senkrechte Chassisanordnungen und grosse Kühlflächen bringen weitere Verbesserungen der Kühlwirkung. Durch Oberflächen mit guten Strahlungseigenschaften liessen sich die Temperaturen im Innern des Wärmeschutzgehäuses auf die Hälfte reduzieren. Einseitig oder gar zweiseitig metallische bLanke Flächen sind dieser Druckschrift zufolge zu verwerfen, wenn diese Wärme abführen sollen.

### Darstellung der Erfindung

Die Erfindung, wie sie im Patentanspruch 1 definiert ist, löst die Aufgabe, eine Wärmeschutzanordnung für mindestens ein elektronisches Gerät anzugeben, das einen verbesserten Wärmeschutz bei von aussen kommender Wärmestrahlung aufweist.

Ein Vorteil der Erfindung liegt darin, dass die Betriebstemperatur für Halbleiterbauelemente des geschützten elektronischen Gerätes tiefer gehalten werden kann und die Ausfallrate der elektronischen Komponeten sinkt. Dies ist besonders dann von Bedeutung, wenn die Elektronik der Sonnenbestrahlung oder anderer intensiver Wärmestrahlung ausgesetzt wird. Im Freien aufgestellte Elektronik muss in den meisten Fällen gegen Umwelteinflüsse (Witterung, Vögel, Mäuse, Wespen usw.) geschützt sein, was eine mechanisch gute und damit thermisch schlechte Kapselung bedingt. Mit dem erfindungsgemässen Wärmeschutzgehäuse kann man erreichen, dass die bestrahlte Aussenwand die absorbierte Wärme praktisch nicht an die geschützte Elektronik weitergibt. Bei einer Ausgestaltung der Erfindung betrug eine durch Sonnenbestrahlung bedingte Temperaturerhöhung im Innern des Wärmeschutzgehäuses nur etwa 1 K.

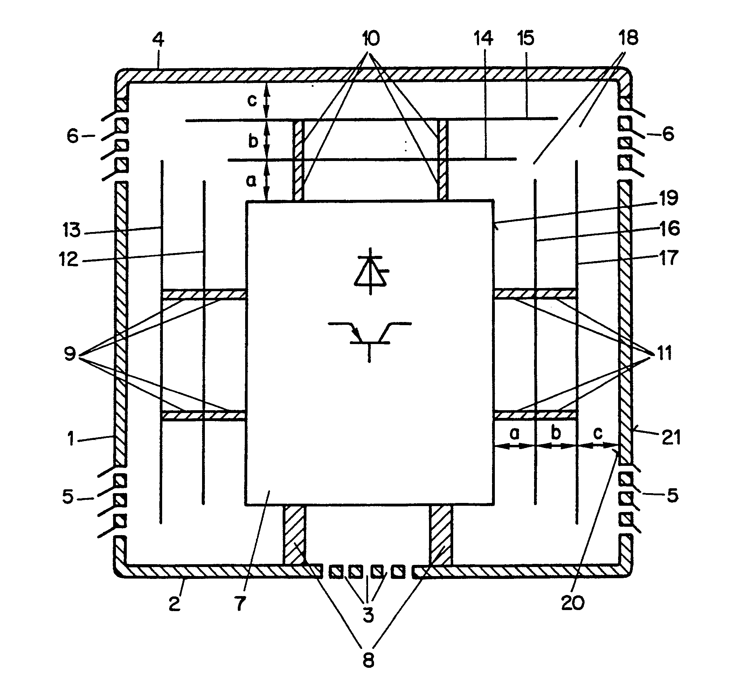

### Kurze Beschreibung der Zeichnung

Die Erfindung wird nachstehend anhand eines Ausführungsbeispiels erläutert. Die einzige Figur zeigt ein Wärmeschutzgehäuse mit einem schematisch dargestellten, elektronischen Gerät im Schnitt.

### Weg zur Ausführung der Erfindung

Ein quaderförmiges Aussengehäuse bzw. Wärmeschutzgehäuse 1 aus 2 mm dickem, rostfreiem Stahl weist einen Boden bzw. eine Bodenplatte 2 mit Lüftungsschlitzen 3 in deren zentralem Bereich und einen nach oben abnehmbaren Deckel bzw. eine Deckplatte 4 auf. Die Deckplatte 4 braucht, um eine gute Belüftung des Innenraumes des Wärmeschutzgehäuses 1 zu gewährleisten, nicht hermetisch dicht angebracht zu sein.

Dicht oberhalb der Bodenplatte 2 sind zumindest in gegenüberliegenden Seitenwänden des Wärmeschutzgehäuses 1 untere Lüftungsschlitze 5 angebracht und dicht unterhalb der Deckplatte 4 obere Lüftungsschlitze 6. Um im Innern des Wärmeschutzgehäuses 1 eine Kaminwirkung zu erzielen, sind in einem möglichst langen Bereich zwischen den unteren und oberen Lüftungsschlitzen 5 und 6 keine Löcher oder Lüftungsschlitze vorgesehen. Die Lüftungsschlitze 5 und 6 sind durch an der Aussenseite des Wärmeschutzgehäuses 1 vorragende Abschrägungen gegen direkte Sonneneinstrahlung und Regeneintritt geschützt.

Im Innern des Wärmeschutzgehäuses 1 ist ein gegen Sonnen- bzw. Wärmeeinstrahlung von aussen zu schützendes, gekapseltes, quaderförmiges elektronisches Gerät 7, vorzugsweise ein elektronisches Signalverarbeitungsgerät für das Messignal eines Stromwandlers, mittels Schrauben bzw. Stützen 8 an der Bodenplatte 2 befestigt. Die Stützen 8 können Isolatoren oder Metallbolzen mit kleinem Querschnitt sein, um eine Wärmeleitung möglichst gering zu halten.

An den vier Seitenwänden des elektronischen Gerätes 7 sind in einem Abstand a von 3 cm innere Strahlungsreflektoren 12 und 16 und in einem Abstand b von 3 cm zu diesen inneren Strahlungsreflektoren weitere äussere Strahlungsreflektoren 13 und 17 vorgesehen. Die äusseren Strahlungsreflektoren 13 und 17 haben von einer seitlichen Innenfläche 20 des Wärmeschutzgehäuses 1 einen Abstand c von 3 cm. Die seitlichen Strahlungsreflektoren 12, 13, 16 und 17 sind mindestens so hoch wie das elektronische Gerät 7, vorzugsweise ragen mindestens die äusseren Strahlungsreflektoren 13 und 17 unten und oben über das elektronische Gerät 7 hinaus, so dass sie dieses seitlich ganz gegenüber dem Wärmeschutzgehäuse 1 abschirmen.

In vorzugsweise gleichen Abständen a, b, c sind oberhalb des elektronischen Gerätes 7 obere Strahlungsreflektoren 14 und 15 vorgesehen, die seitlich von den seitlichen Strahlungsreflektoren 12, 13, 16 und 17 beabstandet sind, so dass zwischen ihnen und den seitlichen Strahlungsreflektoren Lüftungsöffnungen 18 bleiben.

Die Strahlungsreflektoren 12 - 17 sind je mit vier Schrauben bzw. Stützen 9 - 11 an gut Wärmestrahlen reflektierenden Seitenwänden bzw. an einer gut reflektierenden Deckplatte des elektronischen Gerätes 7 befestigt. Die Stützen 9 - 11 sollen die Wärme schlecht leiten. Alle Strahlungsreflektoren 12 - 17 bestehen aus 1 mm dickem Aluminiumblech mit beidseitig polierter und entfetteter Oberfläche mit einem Reflexionskoeffizienten von ≥ 0,8. Wichtig ist, dass der Reflexionskoeffizient jedes Strahlungsreflektors 12 - 17 wenigstens auf seiner dem Wärmeschutzgehäuse 1 zugewandten Fläche grösser als 0,5, vorzugsweise grösser als 0,8 ist. Die Deckplatte und seitliche Oberflächen 19 des elektronischen Gerätes 7 sowie die seitliche Innenfläche 20 und die Innenfläche der Deckplatte 4 des Wärmeschutzgehäuses 1 sind ebenfalls gut reflektierend bezüglich Wärmestrahlen ausgebildet mit einem Reflexionskoeffizienten ≥ 0,5. Die vier seitlichen Aussenflächen 21 und die Aussenfläche der Deckplatte 4 des Wärmeschutzgehäuses 1 sind lackiert und damit witterungsbeständig.

Die Strahlungsreflektoren 12 - 17 bewirken, dass die von der seitlichen Innenfläche 20 und der Innenfläche der Deckplatte 4 des Wärmeschutzgehäuses 1 nach innen abgestrahlte Wärme reflektiert wird, so dass die Aussenwand die gesamte Wärme durch Strahlung und durch Konvektion nur nach aussen abgeben kann. Die aufgewärmte seitliche Aussenwand des Wärmeschutzgehäuses 1 erzwingt auch im Inneren des Wärmeschutzgehäuses eine Luftströmung aufwärts, so dass durch die unteren Lüftungsschlitze 5 die durch Strahlung nicht erwärmte Umgebungsluft eingesaugt wird, welche wiederum Strahlungswärme von aussen und die durch den Betrieb der Elektronik entstandene Wärme durch die oberen Lüftungsschlitze 6 abführt. Die Kühlschlitze 3 in der Bodenplatte 2 unterstützen die Kühlwirkung für das elektronische Gerät 7.

Ein guter Wärmeschutz wird bereits mit nur je einem seitlichen Strahlungsreflektor 13, 17 zwischen den Seitenwänden des Wärmeschutzgehäuses 1 und dem elektronischen Gerät 7 erreicht. Der Abstand c sollte nicht kleiner als 5 mm sein.

Die Strahlungsreflektoren können auch streifenförmig ausgebildet und von innen nach aussen versetzt angeordnet sein, so dass das elektronische Gerät 7 zumindest seitlich ganz durch Strahlungsreflektoren abgeschirmt ist.

Anstelle der Strahlungsreflektoren 12 - 17 aus Aluminiumblech können auch Doppelfenster mit zwei voneinander beabstandeten und abgedichteten, innenverspiegelten Glasscheiben verwendet werden. Wichtig ist, dass Wärme nach aussen abgestrahlt wird.

Die Abstände a - c können grösser als 0,5 cm gewählt werden.

Anstelle eines quaderförmigen Wärmeschutzgehäuses 1 kann selbstverständlich auch z.B. ein kreiszylindrisches gewählt werden, wobei kreiszylindrische oder streifenförmige seitliche Strahlungsreflektoren verwendet werden.

## Ansprüche

1. Wärmeschutzanordnung (1) eines elektronischen Gerätes (7), insbesondere für Hochspannungsfreiluftanlagen,

a) welche Wärmeschutzanordnung das elektronische Gerät allseits umschliesst und

b) nahe einer Bodenplatte (2) untere Lüftungsöffnungen (5) sowie

c) nahe einer Deckplatte (4) obere Lüftungsöffnungen (6) aufweist, dadurch gekennzeichnet,

d) dass zwischen dem elektronischen Gerät (7) und mindestens einer das elektronische Gerät seitlich umgebenden Wand der Wärmeschutzanordnung (1), in vorgebbarem Abstand (c) zu dieser und in vorgebbarem Abstand (a, b) zu dem elektronischen Gerät (7), mindestens ein seitlicher Strahlungsreflektor (12, 13 ; 16, 17) angeordnet ist.

2. Wärmeschutzanordnung nach Anspruch 1, dadurch gekennzeichnet,

a) dass zwischen dem elektonischen Gerät (7) und der Deckplatte (4) der Wärmeschutzanodnung (1), in vorgebbarem Abstand zu dieser und in vorgebbarem Abstand zu dem elektronischen Gerät (7), mindestens ein oberer Strahlungsreflektor (14, 15) angeordnet ist und

b) dass der obere Strahlungsreflektor von dem mindestens einen seitlichen Strahlungsreflektor (12, 13 ; 16, 17) beabstandet ist, derart, dass zwischen jedem oberen und seitlichen Strahlungsreflektor eine Lüftungsöffnung (18) bleibt.

3. Wärmeschutzanordnung nach einem der Ansprüche 1 oder 2, dadurch gekennzeichnet,

a) dass mindestens die seitliche Oberfläche (19) des elektronischen Gerätes (7) und

b) mindestens die seitliche Innenfläche (20) der Wärmeschutzanordnung(1) als Reflektoren für Wärmestrahlen ausgebildet sind.

4. Wärmeschutzanordnung nach einem der Ansprüche 1 bis 3, dadurch gekennzeichnet,

a) dass der Reflexionskoeffizient jedes Strahlungsreflektors (12 - 17) wenigstens auf seiner dem Wärmeschutzgehäuse (1) zugewandten Fläche grösser als 0,5 ist,

b) insbesondere grösser als 0,8 ist.

5. Wärmeschutzanordnung nach einem der Ansprüche 1 bis 4, dadurch gekennzeichnet, dass die Strahlungsreflektoren (12 - 17) Oberflächen aus poliertem Aluminium aufweisen.

6. Wärmeschutzanordnung nach Anspruch 5, dadurch gekennzeichnet, dass die Oberflächen wenigstens der Strahlungsreflektoren (12 - 17) entfettet sind.

7. Wärmeschutzanordnung nach einem der Ansprüche 1 bis 6, dadurch gekennzeichnet, dass die Strahlungsreflektoren (12 - 17) an dem elektronischen Gerät (7) oder an einem Abschirmgehäuse des elektronischen Gerätes befestigt sind.

8. Wärmeschutzanordnung nach einem der Ansprüche 1 bis 7, dadurch gekennzeichnet, dass wenigstens im zentralen Bereich der Bodenplatte (2) Lüftungsöffnungen (3) vorgesehen sind.

9. Wärmeschutzanordnung nach einem der Ansprüche 1 bis 8, dadurch gekennzeichnet,

a) dass wenigstens die seitliche Aussenfläche (21) der Wärmeschutzanordnung(1) gut reflektierend für Wärmestrahlen ausgebildet ist,
b) insbesondere, dass der Reflexionskoeffizient mindestens der seitlichen Aussenfläche (21) > 0,3 ist.

10. Wärmeschutzanodnung nach einem der Anspruch 1 bis 9, darduch gekennzeichnet, dass die seitlichen Strahlungsreflektoren (12, 13 ; 16, 17) mindestens so hoch sind wie die Höhe des elektronischen Gerätes (7).

## Claims

1. Heat protection arrangement (1) of an electronic device (7), particularly for outdoor high-voltage installations,

a) which heat protection arrangement encloses the electronic device on all sides and
b) exhibits lower ventilation openings (5) close to a bottom plate (2) and
c) upper ventilation openings (6) close to a coverplate (4) characterized in that
d) between the electronic device (7) and at least one wall of the heat protection arrangement (1) which laterally surrounds the electronic device, at least one lateral radiation reflector (12, 13 ; 16, 17) is arranged at a predeterminable distance (c) to this wall and at a predeterminable distance (a, b) to the electronic device (7).

2. Heat protection arrangement according to Claim 1, characterized in that

a) between the electronic device (7) and the coverplate (4) of the heat protection arrangement (1) at least one upper radiation reflector (14, 15) is arranged at a predeterminable distance from this coverplate and at a predeterminable distance from the electronic device (7), and that
b) the upper radiation reflector is spaced apart from at least one lateral radiation reflector (12, 13 ; 16, 17), in such a manner that a ventilation opening (18) remains between each upper and lateral radiation reflector.

3. Heat protection arrangement according to one of Claims 1 or 2, characterized in that

a) at least the lateral surface (19) of the electronic device (7) and
b) at least the lateral inside surface (20) of the heat protection arrangement (1) are constructed as reflectors for heat rays.

4. Heat protection arrangement according to one of Claims 1 to 3, characterized in that

a) the reflection coefficient of each radiation reflector (12 - 17) is greater than 0.5 at least on its surface facing the heat protection casing (1),
b) in particular greater than 0.8

5. Heat protection arrangement according to one of Claims 1 to 4, characterized in that the radiation reflectors (12 - 17) exhibit surfaces of polished aluminium.

6. Heat protection arrangement according to Claim 5, characterized in that the surfaces of at least the radiation reflectors (12 - 17) are degreased.

7. Heat protection arrangement according to one of Claims 1 to 6, characterized in that the radiation reflectors (12 - 17) are attached to the electronic device (7) or to a shielding casing of the electronic device

8. Heat protection arrangement according to one of Claims 1 to 7, characterized in that ventilation openings (3) are provided at least in the central area of the bottom plate (2).

9. Heat protection arrangement according to one of Claims 1 to 8, characterized in that

a) at least the lateral outside surface (21) of the heat protection arrangement (1) is constructed to be a good reflector for heat rays,
b) in particular, that the reflection coefficient of at least the lateral outside surface (21) is > 0.3

10. Heat protection arrangement according to one of Claims 1 to 9, characterized in that the lateral radiation reflectors (12, 13 ; 16, 17) are at least as high as the height of the electronic device (7).

## Revendications

1. Dispositif d'isolation thermique (1) d'un appareil électronique (7), en particulier d'une installation extérieure à haute tension,

(a) lequel dispositif d'isolation thermique entoure de tous côtés l'appareil électronique, et

(b) présente des ouvertures d'aération inférieures (5) à proximité d'une plaque de fond (2) ainsi que

(c) des ouvertures d'aération supérieures (6) à proximité d'une plaque de couvercle (4), caractérisé en ce que

(d) entre l'appareil électronique (7) et au moins une paroi du dispositif d'isolation thermique (1) entourant latéralement l'appareil électronique (7), est disposé au moins un réflecteur de rayonnement latéral (12, 13 ; 16, 17) à une distance prédéterminée (c) du premier et à une distance prédéterminée (a, b) de l'appareil électronique (7).

2. Dispositif d'isolation thermique suivant la revendication 1, caractérisé en ce que

(a) entre l'appareil électronique (7) et la plaque de couvercle (4) du dispositif d'isolation thermique (1), à une distance prédéterminée de celle-ci et à une distance prédéterminée de l'appareil électronique (7), est disposé au moins un réflecteur de rayonnement supérieur (14, 15), et en ce que

(b) le réflecteur de rayonnement supérieur est espacé dudit au moins un réflecteur de rayonnement latéral (12, 13 ; 16, 17) de telle sorte qu'il subsiste une ouverture d'aération (18) entre chaque réflecteur de rayonnement supérieur et chaque réflecteur de rayonnement latéral.

3. Dispositif d'isolation thermique suivant l'une des revendications 1 ou 2, caractérisé en ce que

(a) au moins la surface latérale (19) de l'appareil électronique (7) et

(b) au moins la surface latérale intérieure (20) du dispositif d'isolation thermique (1) constituent des réflecteurs pour les rayonnements thermiques.

4. Dispositif d'isolation thermique suivant l'une ou l'autre des revendications 1 à 3, caractérisé en ce que

(a) le coefficient de réflexion de chaque réflecteur de rayonnement (12 - 17) est, au moins sur sa face tournée vers le dispositif d'isolation thermique (1), supérieur à 0,5,

(b) et en particulier supérieur à 0,8.

5. Dispositif d'isolation thermique suivant l'une ou l'autre des revendications 1 à 4, caractérisé en ce que les réflecteurs de rayonnement (12 - 17) présentent des surfaces en aluminium poli.

6. Dispositif d'isolation thermique suivant la revendication 5, caractérisé en ce que les surfaces d'au moins les réflecteurs de rayonnement (12 - 17) sont dégraissées.

7. Dispositif d'isolation thermique suivant l'une ou l'autre des revendications 1 à 6, caractérisé en ce que les réflecteurs de rayonnement (12 - 17) sont fixés à l'appareil électronique (7) ou à un blindage de l'appareil électronique.

8. Dispositif d'isolation thermique suivant l'une ou l'autre des revendications 1 à 7, caractérisé en ce qu'il est prévu des ouvertures d'aération (3) au moins dans la région centrale de la plaque de fond (2).

9. Dispositif d'isolation thermique suivant l'une ou l'autre des revendications 1 à 8, caractérisé en ce que (a) au moins la surface latérale extérieure (21) du dispositif d'isolation thermique (1) est bien réfléchissante pour les rayonnements thermiques, (b) et en particulier en ce que le coefficient de réflexion au moins de la surface latérale extérieure (21) est > 0,3.

10. Dispositif d'isolation thermique suivant l'une ou l'autre des revendications 1 à 9, caractérisé en ce que les réflecteurs de rayonnement latéraux (12, 13 ; 16, 17) ont une hauteur au moins égale à la hauteur de l'appareil électronique (7).